# EUROPEAN PATENT SPECIFICATION

(11) **EP 3 640 974 B1**
(45) Date of publication and mention of the grant of the patent: **17.02.2021**
(21) Application number: 19201398.5
(22) Date of filing: 04.10.2019
(51) Int. Cl.: H01L 21/48, H01S 5/022, B21J 5/02, B21K 23/04, B21D 28/16

(54) **METHOD OF MANUFACTURING EYELET**
VERFAHREN ZUR HERSTELLUNG EINER ÖSE
PROCÉDÉ DE FABRICATION D'UN OEILLET

(30) Priority: 18.10.2018 JP 2018196754
(43) Date of publication of application: 22.04.2020
(73) Proprietor: SHINKO ELECTRIC INDUSTRIES CO., LTD., Nagano-shi, Nagano 381-2287 (JP)
(72) Inventor: OUCHI, Masato, Nagano-shi, Nagano 381-2287 (JP)
(74) Representative: Regimbeau

(56) References cited:
- WO-A1-2015/113746
- JP-A- 2000 102 826
- JP-A- 2004 255 454
- JP-B1- 6 293 350

## Description

### FIELD

The embodiments discussed herein relate to a method of manufacturing an eyelet.

### BACKGROUND

A metal eyelet is used, for example, in a light emitting device including a laser diode. In such a light emitting device, an eyelet is generally in a cylindrical shape, and a laser diode is mounted on the eyelet, and a heat sink or the like is provided as needed. Also, a lead electrically insulated from the eyelet and electrically connected to the laser diode is provided. Eyelets may be used for products other than light emitting devices.

For manufacturing an eyelet, for example, a metal member having a plate shape is prepared, the metal member is pressed to form a first processed product, and the outer peripheral portion of the first processed product is removed by shaving to form a second processed product. Also, a through hole is formed as needed.

In the method of manufacturing an eyelet described above, the first processed product is formed to have a cylindrical portion having a smaller diameter than the metal member before being processed. Then, the cylindrical portion having a small diameter is shaved from an outer peripheral portion of the upper surface in a direction perpendicular to the upper surface to form the second processed product. Although a shear surface and a fracture surface are formed on the outer peripheral surface of the eyelet, which is the second processed product, it is preferable to make a long shear surface in order to enhance the joint reliability of a member such as a cap joined to the outer peripheral surface of the eyelet.

Patent document JP 6 293350 B1 forms the basis for the preamble of claim 1.

### [Related-Art Documents]

### [Patent Document]

[Patent Document 1] International Publication Pamphlet No. WO 2015/113746

However, while shaving is a general press-processing method for lengthening a shearing surface, when a shaving distance is long, a portion, where a portion of the thickness of a scrap from shaving is added to the thickness of a portion that is essentially punched, is punched. Therefore, a required shear length may not be obtained.

In view of the above, an object in one aspect of the embodiments is to provide a method of manufacturing an eyelet that can increase a shear surface of an outer peripheral surface.

### SUMMARY

According to an aspect of the embodiments, a method of manufacturing an eyelet (10, 10A) includes: a first processing step of preparing a metal member (90) and forming a first processed product (100, 100A) of the metal member (90); and a second processing step of punching the first processed product (100, 100A) to form a second processed product, wherein in the first processing step, the first processed product (100, 100A) is formed to have a plate-shaped portion (120) and a cylindrical portion (110) protruding from an area excluding a peripheral portion (125) of one surface of the plate-shaped portion (120), an outer peripheral surface (110c) of the cylindrical portion (110) being a shear surface, and wherein in the second processing step, a lower die (530) in which a hole (530x) is formed in a thickness direction from a placement surface (530a) is prepared, the cylindrical portion (110) is inserted in the hole (530x), the peripheral portion (125) is supported in contact with the placement surface (530a), and by an upper die (540) having a diameter smaller than that of the hole (530x), an entirety of the cylindrical portion (110) and a part of the plate-shaped portion (120) are punched out from the plate-shaped portion (120) side.

### BRIEF DESCRIPTION OF DRAWINGS

FIG. 1 is a diagram illustrating an example of an eyelet according to a first embodiment;
FIG. 2 is a diagram illustrating an example of a step of manufacturing the eyelet according to the first embodiment (part 1);
FIG. 3 is a diagram illustrating an example of a step of manufacturing the eyelet according to the first embodiment (part 2);
FIG. 4 is a diagram illustrating an example of a step of manufacturing an eyelet according to a comparative example (part 1);
FIG. 5 is a diagram illustrating an example of a step of manufacturing the eyelet according to the comparative example (part 2);
FIG. 6 is a diagram illustrating an example of a step of manufacturing an eyelet according to a modified example 1 of the first embodiment (part 1);
FIG. 7 is a diagram illustrating an example of a step of manufacturing the eyelet according to the modified example 1 of the first embodiment (part 2); and
FIG. 8 is a diagram illustrating an example of a light emitting device according to a second embodiment.

### DESCRIPTION OF EMBODIMENTS

In the following, embodiments will be described with reference to the accompanying drawings. In these drawings, the same elements are referred to by the same references, and duplicate descriptions may be omitted as appropriate.

### <First Embodiment>

### [Structure of Eyelet According to First Embodiment]

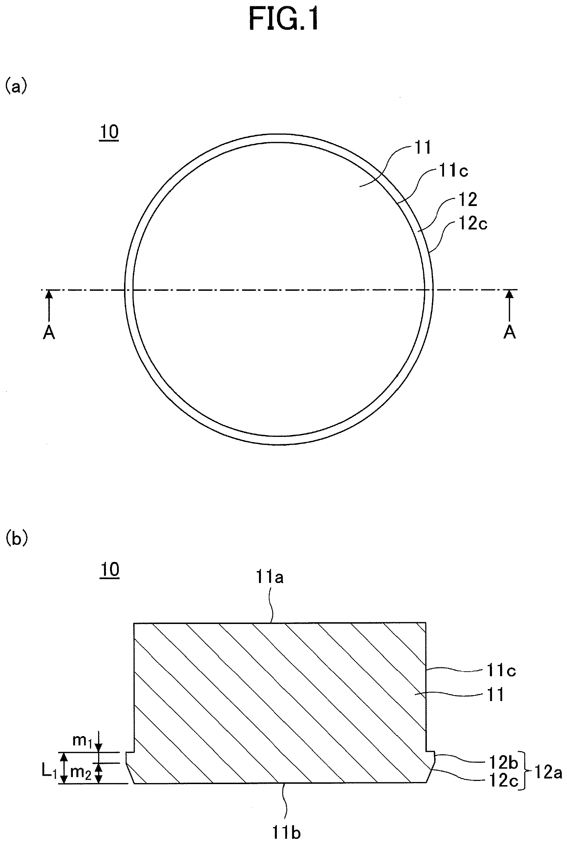

First, a structure of an eyelet 10 according to a first embodiment will be described. FIG. 1 is a diagram illustrating an example of the eyelet 10 according to the first embodiment. FIG. 1 (a) is a plan view of the eyelet 10, and FIG. 1 (b) is a cross-sectional view of the eyelet 10 taken along the line A-A of FIG. 1 (a).

With reference to FIG. 1, the eyelet 10 according to the first embodiment includes a base portion 11 and a step portion 12.

The base portion 11 is a cylindrical member. The base portion 11 includes one surface 11a, the other surface 11b, and an outer peripheral surface 11c.

The step portion 12 is formed integrally with the base portion 11 on the other surface 11b side of the base portion 11, and annularly protrudes from one end side of the outer peripheral surface 11c of the base portion 11 toward the outside in the horizontal direction. The outer peripheral surface 12a of the step portion 12 includes a surface 12b formed substantially parallel to the outer peripheral surface 11c of the base portion 11 and includes a surface 12c tapered toward the other surface 11b of the base portion 11.

Note that in the present application, the "cylindrical shape" refers to one whose planar shape is a substantially circular shape and having a predetermined thickness. The size of the thickness with respect to the diameter is not limited. Also, one in which a recess, a protrusion, or the like is partially formed may be included as the "cylindrical shape". Also, in the present application, a plan view refers to a view of an object taken in a direction normal to one surface 11a of the base portion 11, and a planar shape refers to the shape of an object viewed in a direction normal to one surface 11a of the base portion 11.

The thickness of the eyelet 10 is not particularly limited and can be determined as appropriate according to the purpose. For example, the thickness of the eyelet 10 may be approximately in a range of 3 mm to 8 mm. The maximum outer diameter of the eyelet 10 (which is the maximum outer diameter including the step portion 12) is not particularly limited and can be determined as appropriate according to the purpose. For example, the maximum outer diameter of the eyelet 10 may be approximately in a range of ϕ3 to ϕ8 mm. Note that the outer diameter of the base portion 11 excluding the area where the step portion 12 is formed and the maximum outer diameter of the step portion 12 are both within dimensional tolerance of the outer diameter of the eyelet 10.

The eyelet 10 can be made of a metal material such as Kovar (which is an alloy obtained by combining nickel and cobalt with iron), iron, an iron-nickel alloy, or SUS304 (stainless steel), for example. A plating process may be applied to the surface of the eyelet 10.

In the eyelet 10, the outer peripheral surface 11c of the base portion 11, excluding the area where the step portion 12 is formed, is a shear surface. Also, in the outer peripheral surface 12a of the step portion 12, the surface 12b is a shear surface and the surface 12c (tapered surface) is a fracture surface.

Here, a shear surface is a smooth surface cut and punched by the cutting edge of a die for pressing, and a diameter that is practically as designed can be obtained. Also, a fracture surface is a rough surface cut, in a tearing manner, by a material pushed by the cutting edge of a die for pressing.

A cap (which will be described later below) is joined to the surface 12b of the step portion 12 and the outer peripheral surface 11c of the base portion 11 of the eyelet 10 by, for example, laser welding or the like. In such a case, for a longer shear surface, the contact area between the smooth surface of the eyelet 10 and the cap increases accordingly, thus, the reliability of their joint is enhanced. Therefore, for the eyelet 10, a manufacturing method is devised so that a length m₂ of the eyelet 10 in the thickness direction at the surface 12c of the step portion 12, which is a fracture surface, is as short as possible. The length m₂ may be, for example, approximately in a range of 0.2 mm to 0.8 mm.

### [Method of Manufacturing Eyelet According to First Embodiment]

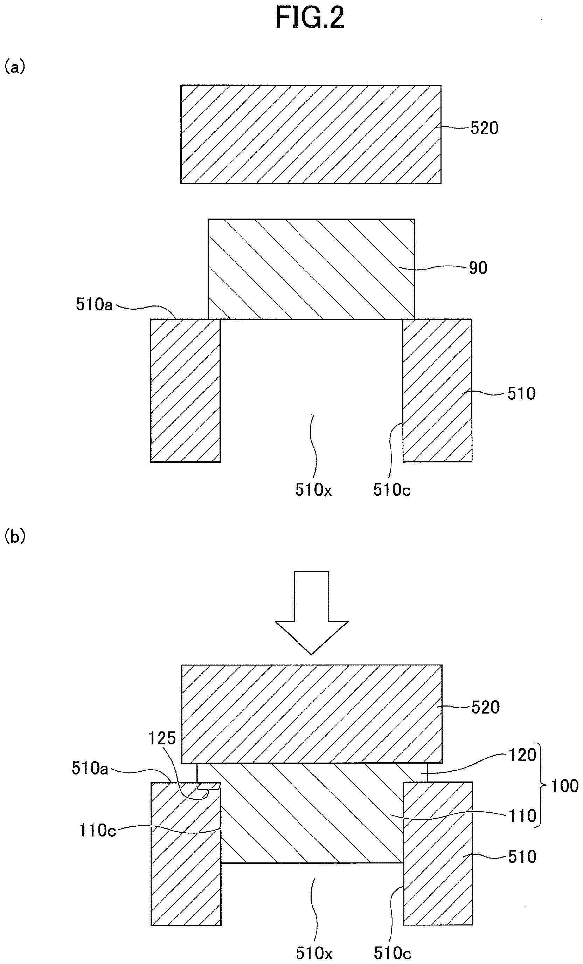

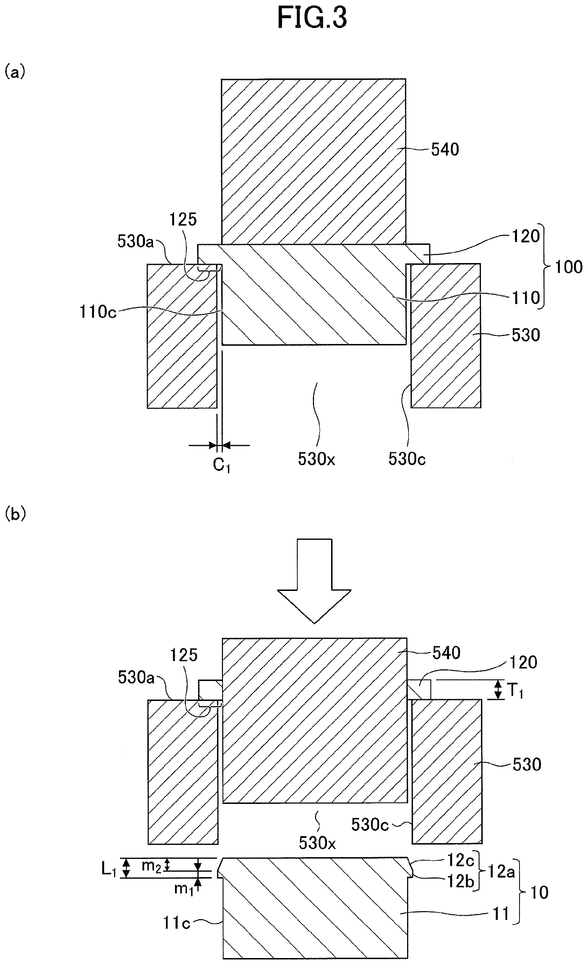

Next, a method of manufacturing the eyelet 10 according to the first embodiment will be described. FIG. 2 and FIG. 3 are diagrams illustrating an example of the manufacturing steps of the eyelet 10 according to the first embodiment.

The step illustrated in FIG. 2 is a first processing step of preparing a metal member 90 having a plate shape (a cylindrical shape, for example) and forming a first processed product 100 of the metal member 90.

First, as illustrated in FIG. 2 (a), the metal member 90 having a plate shape (a cylindrical shape, for example) formed of a metal material such as Kovar, iron, an iron-nickel alloy, or SUS is prepared. Then, the metal member 90 is placed on a die 510, which is a lower die. Further, a shaping punch 520, which is an upper die, is disposed above the metal member 90. The die 510 is formed with a circular hole 510x in the thickness direction from a placement surface 510a, and the metal member 90 is placed on the placement surface 510a of the die 510 to block the hole 510x. The metal member 90 is placed such that the peripheral portion of the lower surface of the metal member 90 is in contact with an area located around the hole 510x of the placement surface 510a of the die 510. Note that the inner diameter of the hole 510x is formed to be substantially equal to the outer diameter of the eyelet 10, which is the end product.

Next, as illustrated in FIG. 2 (b), the shaping punch 520 is lowered in the direction of the arrow to apply pressure to (press) the metal member 90. The lower surface side of the metal member 90 enters the hole 510x, and the first processed product 100 is formed having a plate-shaped portion 120 and a cylindrical portion 110 protruding from an area other than a peripheral portion 125 of the lower surface of the plate-shaped portion 120. An outer peripheral surface 110c of the cylindrical portion 110 and an inner peripheral surface 510c of the hole 510x are in contact with each other. The outer peripheral surface 110c of the cylindrical portion 110 is a shear surface. The outer diameter of the cylindrical portion 110 is formed to be within dimensional tolerance of the outer diameter of the eyelet 10, which is the end product.

The step illustrated in FIG. 3 is a second processing step of punching the first processed product 100 to form the eyelet 10, which is a second processed product.

First, as illustrated in FIG. 3 (a), a die 530 is prepared that is a lower die in which a hole 530x having a circular shape as a planar shape is formed in the thickness direction from a placement surface 530a. The first processed product 100 is then placed on the die 530 such that the cylindrical portion 110 is inserted in the hole 530x and the peripheral portion 125 is supported in contact with the placement surface 530a. Further, on the first processed product 100, a cylindrical trim punch 540, which is an upper die having a diameter smaller than that of the hole 530x, is disposed. The first processed product 100 is placed on the die 530 such that the outer peripheral side of the peripheral portion 125 of the plate-shaped portion 120 is in contact with the placement surface 530a of the die 530, which is located around the hole 530x.

Note that the inner diameter of the hole 530x is formed to be larger than the outer diameter of the cylindrical portion 110. That is, in the secondary processing step, in a state in which a clearance (gap) C₁ is formed between an outer peripheral surface 110c of a cylindrical portion 110 and the inner peripheral surface 530c of the hole 530x, the first processed product 100 is supported by the die 530. The clearance C₁ between the outer peripheral surface 110c of the cylindrical portion 110 and the inner peripheral surface 530c of the hole 530x can be, for example, in a range of approximately 3 µm to 20 µm.

Next, as illustrated in FIG. 3 (b), the trim punch 540 is lowered in the direction of the arrow such that the trim punch 540 punches out the entirety of the cylindrical portion 110 and a part of the plate-shaped portion 120 from the plate-shaped portion 120 side (from above). Thereby, the entirety of the cylindrical portion 110 and the part of the plate-shaped portion 120 are cut out from the first processed product 100 such that the eyelet 10, which is the secondary processed product, is formed. The eyelet 10 has a structure including a base portion 11 formed of the entirety of the cylindrical portion 110 and a part of the plate-shaped portion 120 (central area of the plate-shaped portion 120) and a step portion 12 annularly protruding with respect to one end side of the outer peripheral surface 11c of the base portion 11 to the outside in the horizontal direction. The step portion 12 is a portion cut out from the outer peripheral side of the plate-shaped portion 120. Note that in the step of FIG. 3 (b), the eyelet 10 is formed in a state vertically inverted with respect to FIG. 1.

Because the outer peripheral surface 110c of the cylindrical portion 110 is not processed in this step, the outer peripheral surface 110c of the cylindrical portion 110 that is a shear surface becomes the outer peripheral surface 11c of the base portion 11 without being changed. That is, the outer peripheral surface 11c of the base portion 11 excluding the area where the step portion 12 is formed is a shear surface. Also, the surface 12b of the step portion 12 that is cut out from the outer peripheral side of the plate-shaped portion 120 is a shear surface, and the surface 12c (tapered surface) is a fracture surface. The length L₁ of the eyelet 10 in the thickness direction at the outer peripheral surface 12a of the step portion 12 is substantially equal to the thickness T₁ of the plate-shaped portion 120.

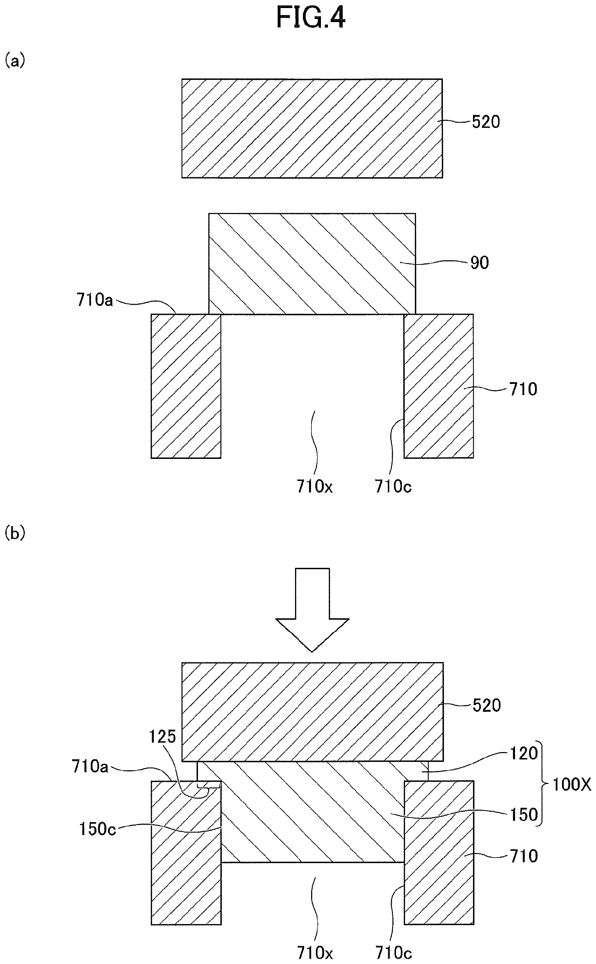

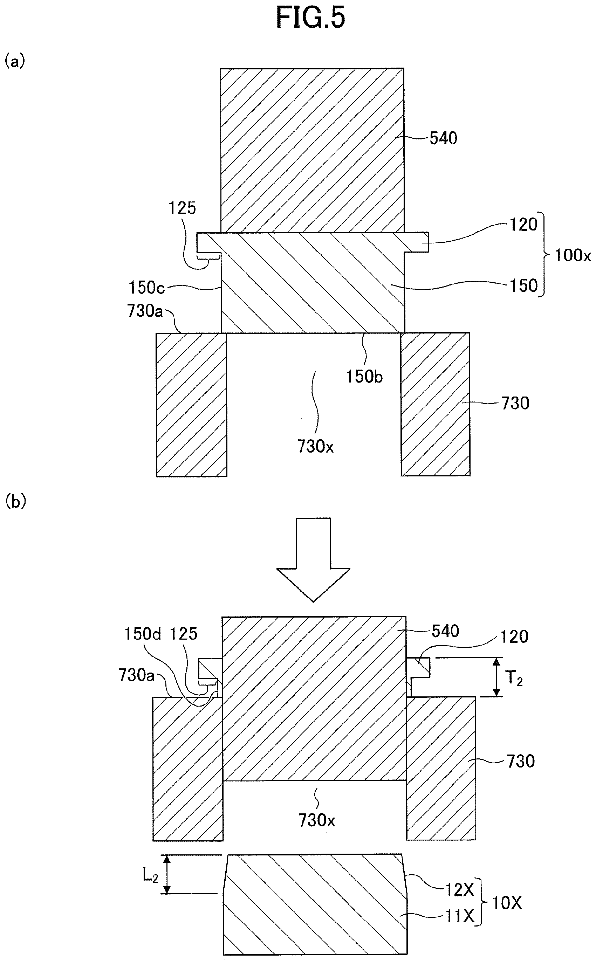

FIGS. 4 and 5 are diagrams illustrating an example of steps of manufacturing an eyelet 10X according to a comparative example. The step illustrated in FIG. 4 is a first processing step.

First, as illustrated in FIG. 4 (a), a metal member 90 is placed on a die 710, which is a lower die. Further, a shaping punch 520, which is an upper die, is disposed above the metal member 90. The die 710 is formed with a hole 710x having a circular shape as a planar shape in the thickness direction from a placement surface 710a, and the metal member 90 is placed on the placement surface 710a of the die 710 to block the hole 710x. The metal member 90 is placed such that the peripheral portion of the lower surface of the metal member 90 is in contact with an area located around the hole 710x of the placement surface 710a of the die 710. Note that differing from the hole 510x illustrated in FIG. 2 (a), the inner diameter of the hole 710x is formed to be larger than the outer diameter of the eyelet 10X, which is the end product.

Next, as illustrated in FIG. 4 (b), the shaping punch 520 is lowered in the direction of the arrow to apply pressure to (press) the metal member 90. The lower surface side of the metal member 90 enters the hole 710x, and a first processed product 100X is formed having a plate-shaped portion 120 and a cylindrical portion 150 protruding from an area other than a peripheral portion 125 of the lower surface of the plate-shaped portion 120. An outer peripheral surface 150c of the cylindrical portion 150 and an inner peripheral surface 710c of the hole 710x are in contact with each other. The outer peripheral surface 150c of the cylindrical portion 150 is a shear surface. The outer diameter of the cylindrical portion 150 is formed to be larger than the outer diameter of the eyelet 10X, which is the end product.

The step illustrated in FIG. 5 is a second processing step. First, as illustrated in FIG. 5 (a), a die 730 is prepared that is a lower die in which a hole 730x having a circular shape as a planar shape is formed in the thickness direction from a placement surface 730a. The first processed product 100X is then placed on the die 730 such that the peripheral portion of the lower surface 150b of the cylindrical portion 150 is in contact with an area located around the hole 730x of the placement surface 730a of the die 730. Further, on the first processed product 100X, a cylindrical trim punch 540, which is an upper die having a diameter smaller than that of the hole 730x, is disposed. Note that the inner diameter of the hole 730x is formed to be substantially equal to the outer diameter of the eyelet 10X, which is the end product.

Next, as illustrated in FIG. 5 (b), the trim punch 540 is lowered in the direction of the arrow such that the trim punch 540 punches out an area other than the peripheral portion of the plate-shaped portion 120 and the peripheral portion of the cylindrical portion 150 from the plate-shaped portion 120 side (from above). Thereby, a part near the outer peripheral surface 150c of the cylindrical portion 150 of the first processed product 100X is shaved and a part of the plate-shaped portion 120 is cut out such that the eyelet 10X, which is the secondary processed product, is formed.

On the eyelet 10X, a base portion 11X having a diameter smaller than that of the cylindrical portion 150 is formed, and a tapered surface 12X is formed on the upper surface side of the base portion 11X. The outer peripheral surface of the base portion 11X other than the tapered surface 12X is a shear surface. Conversely, the tapered surface 12X cut out from the outer peripheral side of the plate-shaped portion 120 is a fracture surface. Note that a portion corresponding to the step portion 12 of the eyelet 10 is not formed on the eyelet 10X.

In FIG. 5 (b), a scrap 150d from shaving is indicated. A length L₂ is longer than the length L₁ (see FIG. 3 (b)) by the thickness of the scrap 150d from shaving. The length m₂ may be, for example, approximately in a range of 0.2 mm to 0.8 mm. In contrast, it is difficult to set the length L₂ to be 0.8 mm or less. For example, the length L₂ is approximately in a range of 1.0 mm to 2.0 mm.

Although shaving is a general press-processing method for lengthening a shearing surface, when a shaving distance is long, because a portion, where the thickness of the scrap 150d from shaving is added to the thickness of the plate-shaped portion 120, is punched, a required shear surface may not be obtained.

Conversely, in the steps of manufacturing the eyelet 10 according to the present embodiment, unlike the steps of manufacturing the eyelet 10X according to the comparative example, because shaving is not performed, a scrap is not generated from shaving. As a result, in the eyelet 10, it is possible to make a shorter fracture surface shorter by the thickness of the scrap 150d from shaving and to make a longer shear surface, in comparison to the eyelet 10X.

### <Modified Example 1 of First Embodiment>

A modified example 1 of the first embodiment is an example in which an additional step is added between the first processing step and the second processing step so as to make the shear surface of an eyelet further longer than that of the first embodiment. Note that in the modified example 1 of the first embodiment, the description of elements that are the same as the embodiment described above may be omitted.

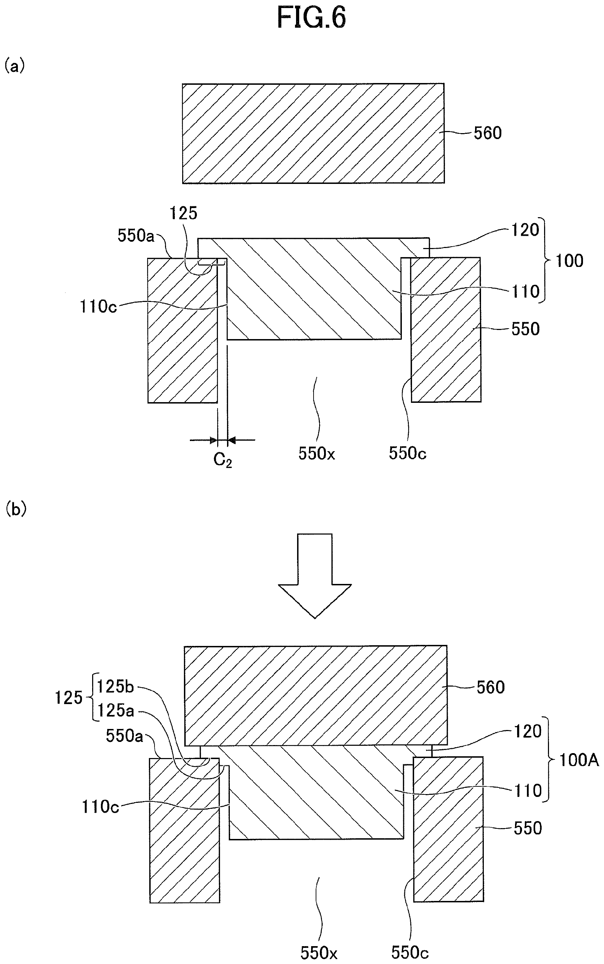

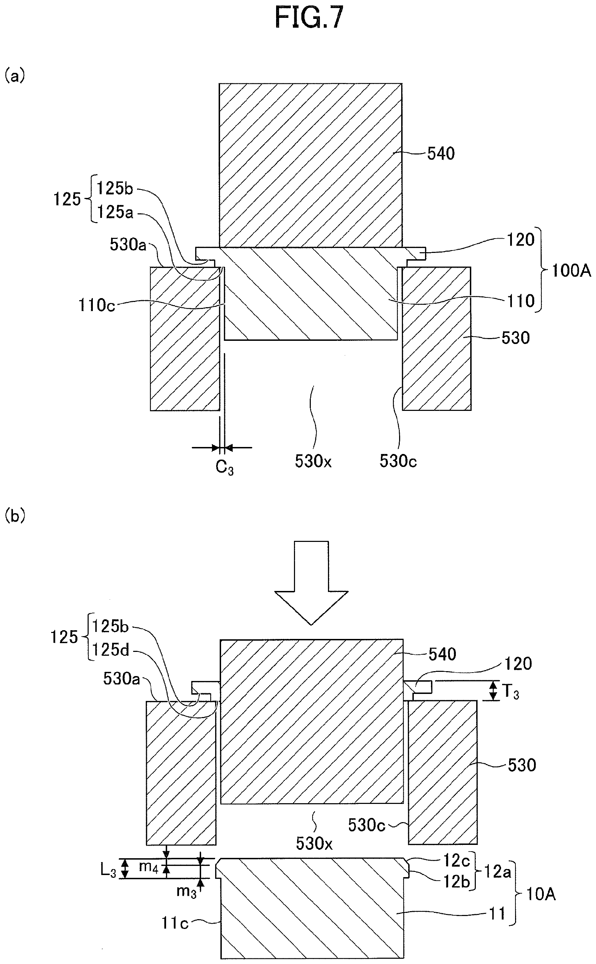

FIG. 6 and FIG. 7 are diagrams illustrating an example of the steps of manufacturing the eyelet according to the modified example 1 of the first embodiment.

First, a step process similar to that of FIG. 2 according to the first embodiment is executed. Then, as illustrated in FIG. 6 (a), a die 550 is prepared that is a lower die in which a hole 550x having a circular shape as a planar shape is formed in the thickness direction from a placement surface 550a. A first processed product 100 is then placed on the die 550 such that a cylindrical portion 110 is inserted in the hole 550x and a peripheral portion 125 is supported in contact with the placement surface 550a. Further, above the first processed product 100, a cylindrical shaping punch 560, which is an upper die having a diameter larger than that of the hole 550x, is disposed. The first processed product 100 is placed on the die 550 such that the outer peripheral side of the peripheral portion 125 of a plate-shaped portion 120 is in contact with the placement surface 550a of the die 550, which is located around the hole 550x.

Note that the inner diameter of the hole 550x is formed to be larger than the outer diameter of the cylindrical portion 110. That is, in a state in which a clearance (gap) C₂ is formed between an outer peripheral surface 110c of the cylindrical portion 110 and an inner peripheral surface 550c of the hole 550x, the first processed product 100 is supported by the die 550. The clearance C₂ between the outer peripheral surface 110c of the cylindrical portion 110 and the inner peripheral surface 550c of the hole 550x is larger than the clearance C₁ (see FIG. 3 (a)) and can be, for example, approximately 100 µm.

Next, as illustrated in FIG. 6 (b), the shaping punch 560 is lowered in the direction of the arrow to apply pressure to (press) the first processed product 100 to thin the outer peripheral side of the peripheral portion 125 of the plate-shaped portion 120. Upon lowering the shaping punch 560 in the direction of the arrow, the inner peripheral side 125a of the peripheral portion 125 of the plate-shaped portion 120 enters the hole 550x, and the outer peripheral side 125b of the peripheral portion 125 is thinned and supported in contact with the placement surface 550a. In this manner, a first processed product 100A having the cylindrical portion 110 and a plate-shaped portion 120 is obtained. On the first processed product 100A, a step is formed between the inner peripheral side 125a and the outer peripheral side 125b of the peripheral portion 125 of the plate-shaped portion 120.

Next, as illustrated in FIG. 7 (a), similarly to FIG. 3 (a), a die 530 is prepared that is a lower die in which a hole 530x having a circular shape as a planar shape is formed in the thickness direction from a placement surface 530a. The first processed product 100A is then placed on the die 530 such that the cylindrical portion 110 is inserted in the hole 530x, the inner peripheral side 125a of the peripheral portion 125 is supported in contact with the placement surface 530a, and the outer peripheral side 125b of the peripheral portion 125 is away from the placement surface 530a. Further, on the first processed product 100A, a cylindrical trim punch 540, which is an upper die having a diameter smaller than that of the hole 530x, is disposed.

Note that the inner diameter of the hole 530x is formed to be larger than the outer diameter of the cylindrical portion 110. That is, in the secondary processing step, in a state in which a clearance (gap) C₃ is formed between the outer peripheral surface 110c of the cylindrical portion 110 and the inner peripheral surface 530c of the hole 530x, the first processed product 100A is supported by the die 530. The clearance C₃ between the outer peripheral surface 110c of the cylindrical portion 110 and the inner peripheral surface 530c of the hole 530x is smaller than the clearance C₂ (see FIG. 6 (a)) and can be, for example, approximately in a range of 3 µm to 20 µm.

Next, as illustrated in FIG. 7 (b), the trim punch 540 is lowered in the direction of the arrow such that the trim punch 540 punches out the entirety of the cylindrical portion 110 and a part of the plate-shaped portion 120 from the plate-shaped portion 120 side (from above). Thereby, a part near the inner peripheral side 125a of the peripheral portion 125 is shaved and the entirety of the cylindrical portion 110 and a part of the plate-shaped portion 120 of the first processed product 100A are cut out such that the eyelet 10A, which is the secondary processed product, is formed. Note that in FIG. 7(b), a scrap 125d from shaving is indicated.

The eyelet 10A has a structure including a base portion 11 formed of the entirety of the cylindrical portion 110 and a part of the plate-shaped portion 120 (central area of the plate-shaped portion 120) and a step portion 12 annularly protruding with respect to one end side of the outer peripheral surface 11c of the base portion 11 to the outside in the horizontal direction. The step portion 12 is a portion cut out from the outer peripheral side of the plate-shaped portion 120.

The outer peripheral surface 110c of the cylindrical portion 110 before being processed is a shear surface. Further, the shaved portion near the inner peripheral side 125a of the peripheral portion 125 of the plate-shaped portion 120 is also a shear surface. Conversely, the surface 12c (tapered surface) of the step portion 12, which is cut out from the outer peripheral side of the plate-shaped portion 120, is a fracture surface.

Although a length L₃ of the step portion 12 is the same length as the length L₁ in FIG. 3 (b), because the scrap 125d is crushed (pressed) at the time of shaving, the thickness T₃ can be made thinner than the thickness T₁. Thus, with respect to the eyelet 10, in eyelet 10A, the length m₃ of the shear surface can be made longer than the length m₁ and the length m₄ of the fracture surface is shorter than the length m₂. The length m₄ can be, for example, in a range of approximately 0.1 mm to 0.7 mm.

### <Second Embodiment>

In a second embodiment, an example of a light emitting device 1 using the eyelet 10 according to the first embodiment will be described. Note that in the second embodiment, descriptions of constituent elements the same as those of the previously provided descriptions may be omitted as appropriate.

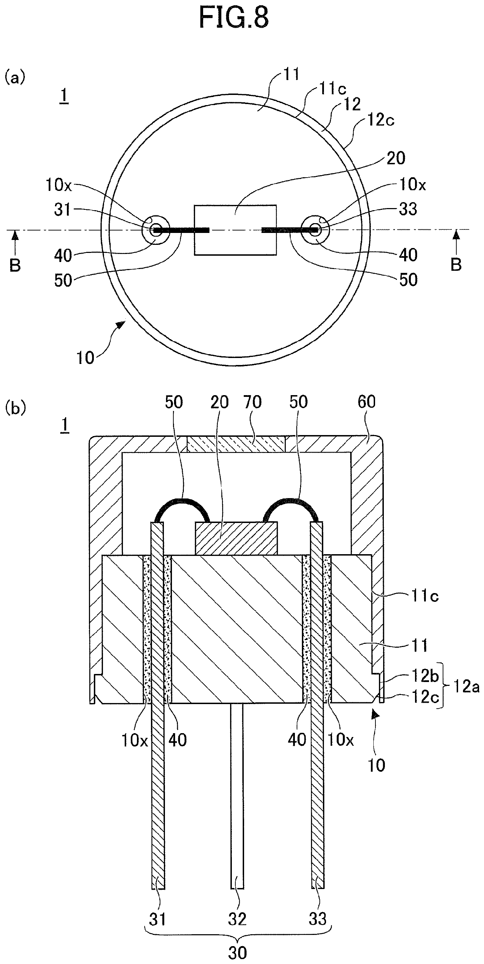

FIG. 8 is a diagram illustrating an example of the light emitting device 1 according to the second embodiment. FIG. 8 (a) is a plan view of the light emitting device 1, and FIG. 8 (b) is a cross-sectional view of the light emitting device 1 taken along the line B-B of FIG. 8 (a).

With reference to FIG. 8, the light emitting device 1 includes the eyelet 10, a light emitting element 20, a lead 30, sealing portions 40, metal wires 50, a cap 60, and a transparent member 70. The light emitting device 1 can be used for, for example, an optical disk device, an optical communication device, or the like. Note that, in FIG. 8 (a), illustration of the cap 60 and the transparent member 70 are omitted.

The light emitting element 20 is, for example, a semiconductor laser chip with a wavelength of 780 nm and is mounted on the upper surface of the eyelet 10 in a state of being insulated from the eyelet 10.

The lead 30 includes a first lead 31, a second lead 32, and a third lead 33. The first lead 31 and the third lead 33 are inserted into through holes 10x penetrating the eyelet 10 in the thickness direction such that their longitudinal directions are directed in the thickness direction, and their outer peripheries are sealed by the sealing portions 40. Parts of the first lead 31 and the third lead 33 protrude downward from the lower surface of the eyelet 10. The amounts of protrusion of the first lead 31 and the third lead 33 from the lower surface of the eyelet 10 may be, for example, approximately 6 mm to 7 mm.

The first lead 31 and the third lead 33 are made of a metal such as Kovar or an iron-nickel alloy, for example. The sealing portions 40 are made of an insulating material such as a glass material, for example. The first lead 31 and the third lead 33 are electrically connected to the light emitting element 20. In a case where a light receiving element is also mounted on the light emitting device 1, the light emitting device 1 may include a lead that is electrically connected to the light receiving element. Also, the number of leads connected to the light emitting element and the light receiving element may be further increased.

The second lead 32 is joined to the lower surface of the eyelet 10 by welding or the like such that its longitudinal direction is directed in the thickness direction to protrude downward from the lower surface of the eyelet 10. The second lead 32 is made of a metal such as Kovar or an iron-nickel alloy, for example, and is used for grounding, for example. Note that the second lead 32 is joined so as to be electrically connected to the eyelet 10, and upon the second lead 32 being grounded, the eyelet 10 is also grounded.

Electrodes (not illustrated) of the light emitting element 20 are connected to upper ends of the first lead 31 and the third lead 33, through the metal wires 50 such as gold wires or copper wires. The electrodes of the light emitting element 20, the first lead 31, and the third lead 33 can be connected through, for example, wire bonding.

The cap 60 is made of, for example, a metal such as iron or copper. The transparent member 70 (window) is provided substantially at the center of the cap 60 in plan view. The transparent member 70 is made of glass or the like, for example, and is bonded to the cap 60 by an adhesive (not illustrated) made of low melting point glass or the like. The cap 60 is joined to the outer peripheral surface 11c of the base portion 11 of the eyelet 10 by, for example, welding or the like, and hermetically seals the light emitting element 20. Light emitted from the light emitting element 20 is emitted passing through the transparent member 70.

Note that the cap 60 may be joined only to the outer peripheral surface 11c of the base portion 11 of the eyelet 10 or may be joined to the outer peripheral surface 11c of the base portion 11 and to the surface 12b of the step portion 12 of the eyelet 10.

In this manner, in the light emitting device 1, the cap 60 is joined, by welding or the like, to the outer peripheral surface 11c of the base portion 11 or to the outer peripheral surface 11c of the base portion 11 and to the surface 12b of the step portion 12 of the eyelet 10. Because the eyelet 10 is manufactured by the manufacturing method described in the first embodiment or the modified example 1 of the first embodiment, the outer peripheral surface 11c of the base portion 11 is a relatively long shear surface. The surface 12b of the step portion 12 is also a shear surface. Therefore, because the contact area between the smooth surface (shear surface) of the eyelet 10 and the cap 60 is increased, the reliability of their joint can be enhanced.

Further, although the preferred embodiments and the modified example have been described above in detail, the present invention is not limited to these embodiments and the modified example, and various variations and modifications may be made without departing from the scope of the appended claims.

For example, although an example in which the eyelet 10 is used for the light emitting device 1 is described in the second embodiment, the eyelet 10 is not limited to this, and may be used for various sensors, inflators, or the like.

## Claims

1. A method of manufacturing an eyelet (10, 10A), the method comprising:
a first processing step of preparing a metal member (90) and forming a first processed product (100, 100A) of the metal member (90); and
a second processing step of punching the first processed product (100, 100A) to form a second processed product,
wherein in the first processing step, the first processed product (100, 100A) is formed to have a plate-shaped portion (120) and a cylindrical portion (110) protruding from an area excluding a peripheral portion (125) of one surface of the plate-shaped portion (120), an outer peripheral surface (110c) of the cylindrical portion (110) being a shear surface, the method being **characterized in that**, in the second processing step, a lower die (530) in which a hole (530x) is formed in a thickness direction from a placement surface (530a) is prepared, the cylindrical portion (110) is inserted in the hole (530x), the peripheral portion (125) is supported in contact with the placement surface (530a), and by an upper die (540) having a diameter smaller than that of the hole (530x), an entirety of the cylindrical portion (110) and a part of the plate-shaped portion (120) are punched out from the plate-shaped portion (120) side.

2. The method of manufacturing the eyelet (10, 10A) according to claim 1, wherein in the second processing step, in a state in which a clearance (C₁, C₃) is formed between the outer peripheral surface (110c) of the cylindrical portion (110) and an inner peripheral surface (530c) of the hole (530x), the first processed product (100, 100A) is supported by the lower die (530).

3. The method of manufacturing the eyelet (10, 10A) according to claim 1 or 2,
wherein the second processed product includes a base portion (11) formed of the entirety of the cylindrical portion (110) and the part of the plate-shaped portion (120) and includes a step portion (12) annularly protruding with respect to one end side of an outer peripheral surface (11c) of the base portion (11) to outside, and
wherein the outer peripheral surface (11c) of the base portion (11) other than an area where the step portion (12) is formed is a shear surface and an outer peripheral surface of the step portion (12) is a fracture surface.

4. The method of manufacturing the eyelet (10, 10A) according to any one of claims 1 to 3, further comprising:
a step of thinning an outer peripheral side of the peripheral portion (125) of the plate-shaped portion (120) between the first processing step and the second processing step,
wherein in the second processing step, the lower die (530) on which the hole (530x) is formed in the thickness direction from the placement surface (530a) is prepared, the cylindrical portion (110) is inserted in the hole (530x), an inner peripheral side (125a) of the peripheral portion (125) is supported in contact with the placement surface (530a), an outer peripheral side (125b) of the peripheral portion (125) is away from the placement surface (530a), and by the upper die (540) having the diameter smaller than that of the hole (530x), the entirety of the cylindrical portion (110) and the part of the plate-shaped portion (120) are punched out from the plate-shaped portion (120) side.

5. The method of manufacturing the eyelet (10, 10A) according to claim 4, wherein in the second processing step, the inner peripheral side (125a) of the peripheral portion (125) is shaved and the entirety of the cylindrical portion (110) and the part of the plate-shaped portion (120) of the first processed product (100A) are cut out.

## Patentansprüche

1. Verfahren zum Herstellen einer Öse (10, 10A), wobei das Verfahren Folgendes umfasst:
einen ersten Verarbeitungsschritt zum Vorbereiten eines Metallelements (90) und Bilden eines ersten verarbeiteten Produkts (100, 100A) des Metallelements (90); und
einen zweiten Verarbeitungsschritt zum Stanzen des ersten verarbeiteten Produkts (100, 100A), um ein zweites verarbeitetes Produkt zu bilden,
wobei das erste verarbeitete Produkt (100, 100A) im ersten Verarbeitungsschritt gebildet wird, um einen plattenförmigen Abschnitt (120) und einen zylindrischen Abschnitt (110), der von einem Bereich vorsteht, der einen Umfangsabschnitt (125) einer Fläche des plattenförmigen Abschnitts (120) ausschließt, umfasst, wobei eine Außenumfangsfläche (110c) des zylindrischen Abschnitts (110) eine Scherfläche ist, wobei das Verfahren **dadurch gekennzeichnet ist, dass**
im zweiten Verarbeitungsschritt ein unteres Werkzeug (530), in dem ein Loch (530x) in einer Dickenrichtung von einer Platzierungsfläche (530a) gebildet ist, vorbereitet wird, der zylindrische Abschnitt (110) in das Loch (530x) gesteckt wird, der Umfangsabschnitt (125) in Kontakt mit der Platzierungsfläche (530a) gestützt wird und von einem oberen Werkzeug (540) mit einem Durchmesser, der kleiner ist als der des Lochs (530x) eine Gesamtheit des zylindrischen Abschnitts (110) und ein Teil des plattenförmigen Abschnitts (120) von der Seite des plattenförmigen Abschnitts (120) ausgestanzt werden.

2. Verfahren zum Herstellen einer Öse (10, 10A) nach Anspruch 1, wobei das erste verarbeitete Produkt (100, 100A) im zweiten Verarbeitungsschritt in einem Zustand, in dem ein Spiel (C₁, C₃) zwischen der Außenumfangsfläche (110c) des zylindrischen Abschnitts (110) und einer Innenumfangsfläche (530c) des Lochs (530x) gebildet ist, vom unteren Werkzeug (530) gestützt wird.

3. Verfahren zum Herstellen einer Öse (10, 10A) nach Anspruch 1 oder 2,
wobei das zweite verarbeitete Produkt einen Basisabschnitt (11) beinhaltet, der aus der Gesamtheit des zylindrischen Abschnitts (110) und dem Teil des plattenförmigen Abschnitts (120) gebildet ist, und einen Stufenabschnitt (12) beinhaltet, der mit Bezug auf eine Endseite einer Außenumfangsfläche (11c) des Basisabschnitts (11) ringförmig nach außen vorsteht, und
wobei die Außenumfangsfläche (11c) des Basisabschnitts (11) außer einem Bereich, in dem der Stufenabschnitt (12) gebildet ist, eine Scherfläche ist und eine Außenumfangsfläche des Stufenabschnitts (12) eine Bruchfläche ist.

4. Verfahren zum Herstellen der Öse (10, 10A) nach einem der Ansprüche 1 bis 3, das ferner Folgendes umfasst:
einen Schritt des Verdünnens einer Außenumfangsseite des Umfangsabschnitts (125) des plattenförmigen Abschnitts (120) zwischen dem ersten Verarbeitungsschritt und dem zweiten Verarbeitungsschritt,
wobei im zweiten Verarbeitungsschritt das untere Werkzeug (530), in dem das Loch (530x) in der Dickenrichtung von der Platzierungsfläche (530a) gebildet ist, vorbereitet wird, der zylindrische Abschnitt (110) in das Loch (530x) gesteckt wird, eine Innenumfangsseite (125a) des Umfangsabschnitts (125) in Kontakt mit der Platzierungsfläche (530a) gestützt wird, eine Außenumfangsseite (125b) des Umfangsabschnitts (125) von der Platzierungsfläche (530a) entfernt ist und vom oberen Werkzeug (540) mit dem Durchmesser, der kleiner ist als der des Lochs (530x), die Gesamtheit des zylindrischen Abschnitts (110) und der Teil des plattenförmigen Abschnitts (120) von der Seite des plattenförmigen Abschnitts (120) ausgestanzt werden.

5. Verfahren zum Herstellen einer Öse (10, 10A) nach Anspruch 4, wobei im zweiten Verarbeitungsschritt die Innenumfangsseite (125a) des Umfangsabschnitts (125) nachgeschnitten wird und die Gesamtheit des zylindrischen Abschnitts (110) und der Teil des plattenförmigen Abschnitts (120) des ersten verarbeiteten Produkts (100A) ausgeschnitten werden.

## Revendications

1. Procédé de fabrication d'un œillet (10, 10A), le procédé comprenant :
une première étape de traitement, de préparation d'un élément métallique (90) et de formation d'un premier produit traité (100, 100A) de l'élément métallique (90) ; et
une deuxième étape de traitement, de poinçonnage du premier produit traité (100, 100A) pour former un deuxième produit traité,
dans lequel, dans la première étape de traitement, le premier produit traité (100, 100A) est formé pour avoir une portion en forme de plaque (120) et une portion cylindrique (110) faisant saillie à partir d'une zone excluant une portion périphérique (125) d'une surface de la portion en forme de plaque (120), une surface périphérique extérieure (110c) de la portion cylindrique (110) étant une surface de cisaillement, le procédé étant **caractérisé en ce que**,
dans la deuxième étape de traitement, une matrice inférieure (530), dans laquelle un trou (530x) est formé dans une direction de l'épaisseur à partir d'une surface de mise en place (530a), est préparée, la portion cylindrique (110) est insérée dans le trou (530x), la portion périphérique (125) est supportée en contact avec la surface de mise en place (530a), et par une matrice supérieure (540) ayant un diamètre plus petit que celui du trou (530x), la totalité de la portion cylindrique (110) et une partie de la portion en forme de plaque (120) sont poinçonnées du côté de la portion en forme de plaque (120).

2. Procédé de fabrication d'œillet (10, 10A) selon la revendication 1, dans lequel, dans la deuxième étape de traitement, dans un état dans lequel un jeu (C₁, C₃) est formé entre la surface périphérique extérieure (110c) de la portion cylindrique (110) et une surface périphérique intérieure (530c) du trou (530x), le premier produit traité (100, 100A) est supporté par la matrice inférieure (530).

3. Procédé de fabrication d'œillet (10, 10A) selon la revendication 1 ou 2,
dans lequel le deuxième produit traité comporte une portion de base (11) formée de la totalité de la portion cylindrique (110) et de la partie de la portion en forme de plaque (120), et comporte une portion étagée (12) faisant saillie de manière annulaire par rapport à un côté d'extrémité d'une surface périphérique extérieure (11c) de la portion de base (11) vers l'extérieur, et
dans lequel la surface périphérique extérieure (11c) de la portion de base (11), autre qu'une zone où la portion étagée (12) est formée, est une surface de cisaillement, et une surface périphérique extérieure de la portion étagée (12) est une surface de fracture.

4. Procédé de fabrication d'œillet (10, 10A) selon l'une quelconque des revendications 1 à 3, comprenant en outre :
une étape d'amincissement d'un côté périphérique extérieur de la portion périphérique (125) de la portion en forme de plaque (120) entre la première étape de traitement et la deuxième étape de traitement,
dans lequel, dans la deuxième étape de traitement, la matrice inférieure (530), sur laquelle le trou (530x) est formé dans la direction de l'épaisseur à partir de la surface de mise en place (530a), est préparée, la portion cylindrique (110) est insérée dans le trou (530x), un côté périphérique intérieur (125a) de la portion périphérique (125) est supporté en contact avec la surface de mise en place (530a), un côté périphérique extérieur (125b) de la portion périphérique (125) est éloigné de la surface de mise en place (530a), et par la matrice supérieure (540) ayant le diamètre plus petit que celui du trou (530x), la totalité de la portion cylindrique (110) et la partie de la portion en forme de plaque (120) sont poinçonnées du côté de la portion en forme de plaque (120).

5. Procédé de fabrication d'œillet (10, 10A) selon la revendication 4, dans lequel, dans la deuxième étape de traitement, le côté périphérique intérieur (125a) de la portion périphérique (125) est rasé, et la totalité de la portion cylindrique (110) et la partie de la portion en forme de plaque (120) du premier produit traité (100A) sont découpées.
